# FASCICULE DE BREVET EUROPEEN

(11) **EP 0 770 228 B1**
(45) Date de publication et mention de la délivrance du brevet: **11.11.1998**
(21) Numéro de dépôt: 95925046.5
(22) Date de dépôt: 12.07.1995
(51) Int. Cl.: G03F 7/24, G03F 5/24, G03F 5/00, G03F 1/00

(54) **UTILISATION DU TRAMAGE A MODULATION DE FREQUENCE POUR ALLEGER EN OFFSET LES SURFACES IMPRIMANTES**
VERWENDUNG FREQUENZMODULIERTER RASTERUNG UM IN OFFSET DIE FARBTRAGENDEN FLÄCHEN ZU UNTERBRECHEN
USE OF FREQUENCY-MODULATED SCREENING FOR LIGHTENING OFFSET PRINTING SURFACES

(30) Priorité: 13.07.1994 FR 9408726
(43) Date de publication de la demande: 02.05.1997
(73) Titulaire: Nouel, Jean-Marie, 77760 Villiers-sous-Grez (FR)
(72) Inventeur: Nouel, Jean-Marie, 77760 Villiers-sous-Grez (FR)
(74) Mandataire: Le Roux, Martine
(86) Numéro de dépôt international: FR9500936
(87) Numéro de publication internationale: WO9602868

(56) Documents cités:
- DE-C- 457 654
- FR-A- 2 026 473
- FR-A- 2 660 245
- US-A- 4 037 533
- US-A- 5 175 804
- US-A- 5 283 154
- DEUTSCHER DRUCKER, vol. 30, no. 6, Février 1994 OSTFILDERN DE, pages W11-W15, P.URBAN 'Die freie Kantenlänge : Indikator der Tonwertzunahme bei frequenzmodulierter Rasterung'
- DEUTSCHER DRUCKER, vol. 30, no. 16, Février 1994 OSTFILDERN DE, pages W14-W15, J. BRUNENBERG 'Erste Praxiserfahrungen mit Feinrastern und FM-Rastern'

## Description

La présente invention concerne l'imprimerie et a plus particulièrement pour objet une utilisation originale du tramage à modulation de fréquence en offset humide ou sec ainsi que des films et plaques modifiées selon ledit tramage.

On sait que les techniques d'impression d'offset humide et d'offset sec ("waterless") utilisent des supports ou plaques qui comportent des surfaces pour prendre l'encre, dites surfaces encrophiles et des surfaces pour refuser ladite encre, dites surfaces non encrophiles. En offset humide, l'encre est refusée par un très mince film d'eau qui adhère sur les surfaces hydrophiles. En offset sec, les surfaces encrophobes sont à base d'un revêtement en silicones (sur lequel l'encre n'adhère pas). Lesdites surfaces encrophiles et non encrophiles sont générées sur lesdites plaques par des techniques d'insolation qui font intervenir des films ou directement à partir de logiciels.

Sur la machine à imprimer, des rouleaux, recouverts d'encre ne déposent celle-ci que sur lesdites surfaces encrophiles d'une plaque. Un blanchet, tissu revêtu de caoutchouc, prend l'encre desdites surfaces encrophiles de ladite plaque et la dépose sur le matériau à imprimer. Il peut s'agir de papier, de carton, de métal...

Il est donc primordial, pour l'obtention d'un résultat correct, que l'encre s'accroche successivement sur les surfaces encrophiles de la plaque puis sur la surface caoutchouteuse du blanchet et qu'enfin elle se dépose sur le matériau à imprimer.

Dans le cadre de l'offset humide, il convient par ailleurs que l'encre se mélange avec un peu de l'eau utilisée pour mouiller les surfaces hydrophiles (encrophobes).

Les images sont réalisées entre deux valeurs, qui sont, d'une part, la valeur "zéro", c'est-à-dire la couleur du matériau à imprimer, vierge, et, d'autre part, une valeur "maximale", c'est-à-dire l'aplat réalisé avec l'encre choisie (le noir, pour de l'encre noire). Toutes les valeurs intermédiaires sont obtenues en utilisant une trame, qui est constituée de milliers de petits carrés. Ceux-ci peuvent être vides - ils représentent une surface blanche, sans encre - partiellement remplis, remplis jusqu'à l'aplat. Toutes les teintes sont ainsi reproduites par des aplats de plus ou moins grande superficie. Lesdits aplats consistent généralement en des points, équidistants les uns des autres, d'un diamètre croissant. On parle de trames à modulation d'amplitude. Avec ce tramage classique, la reproduction d'une image demi-ton passe par la disposition à égale distance de points dont la taille varie proportionnellement à la valeur des tons de l'original.

Les trames sont qualifiées par leur nombre de linéatures au pouce linéaire.

Suivant le procédé d'imprimerie mis en oeuvre et la nature du matériau à imprimer, on utilise des trames plus ou moins fines telles que des trames 65, 80, 100, 120, 150, 175.

Les papiers ordinaires, bon marché, tel le papier journal, requièrent un film d'encre fluide et épais pour couvrir leur surface rugueuse et absorbante. Pour imprimer de tels papiers, on devra utiliser une grosse trame: 65 ou 80, par exemple. Les très beaux papiers, qui présentent une surface lisse et homogène, peuvent eux être imprimés avec un film d'encre, mince et concentré en pigments. Dans ce contexte, une trame très fine, 150 par exemple, pourra être utilisée.

En mettant en oeuvre les techniques classiques dont on a rappelé ci-dessus les principales caractéristiques, on rencontre fréquemment des problèmes du type de ceux exposés ci-après.
- Le mélange eau-encre, en offset humide, ne se fait pas toujours de façon satisfaisante. Il peut contenir trop d'eau ou inversement pas assez d'eau. La qualité et la productivité de l'impression sont alors pénalisées dans la mesure où ladite encre peut baver, mal sécher, rester sur le blanchet...
- Le matériau à imprimer, tel le papier, ne prend pas toujours toute l'encre déposée sur le blanchet. Celle-ci s'accumule, "monte en épaisseur" sur ledit blanchet. Il est alors nécessaire d'interrompre l'impression et de laver ledit blanchet.
- La surface du matériau à imprimer tel le papier laisse sur le blanchet des résidus, sous forme de poussières. Le volume de ses résidus est d'autant plus important que la qualité du matériau à imprimer est moindre. Lorsque ledit volume atteint certaines limites, il convient également de laver le blanchet.
- L'encre déposée sur le blanchet accroche le matériau à imprimer. Si celui-ci est fragile (cas du papier) il va, de temps en temps, se déchirer. Des morceaux de celui-ci restent alors collés sur ledit blanchet. Il faut alors enlever lesdits morceaux, laver le blanchet.
- Sur les machines-feuilles, il y a également un problème particulier dans la mesure où de la même façon l'encre, déposée sur le blanchet, "colle", "tire" le matériau à imprimer (la feuille de papier). Celui-ci, maintenu par des pinces, glisse alors très légèrement. Tout glissement, même de très faible amplitude, entraîne une déformation de l'impression nommée doublage.
- En offset humide, la reproduction des images tramées subit systématiquement un grossissement, de plus ou moins forte amplitude, qualifié d"'engraissement". Cet "engraissement" affecte beaucoup la qualité de l'impression, elle l'alourdit notamment sur les papiers bon marché (papiers qui obligent les imprimeurs à travailler avec des encres fluides).
- En offset sec, les encres utilisées sont plus fermes. En conséquence, l'"engaissement" est moindre. Par contre, lesdites encres fermes ont tendance à "tirer" le matériau à imprimer, notamment le papier, et donc à ne pouvoir être utilisées que sur des papiers d'une certaine qualité.

Le déposant, confronté aux problèmes ci-dessus, a préconisé, notamment pour diminuer l'"engraissement" et faciliter l'impression, d'alléger ladite impression, plus précisément de créer de petites surfaces non encrophiles dans les surfaces encrophiles. Cette technique d'allégement a été décrite dans la demande de brevet FR-A-2660 245. Elle a donné de bons résultats notamment sur des papiers mats et/ou ordinaires mais sa mise en oeuvre, à l'échelle industrielle, notamment sur des papiers couchés et/ou lisses est délicate.

En effet, en utilisant, par exemple, pour ledit allégement, une trame 120 et une valeur de 5 %, on génère, dans les surfaces encrophiles des surfaces non encrophiles de 2 240 µm². Un tel allégement fait disparaître, en partie voire en totalité, un trop grand nombre des points qui constituent la surface encrophile représentant le document à imprimer.. On fait sauter de l'impression et cela peut se voir dans les détails. On perd également en densité. Ceci s'est révélé inacceptable dans de trop nombreux travaux.

En utilisant, pour le même allégement de 5 %, une trame beaucoup plus fine, une trame 600 par exemple, on génère, dans les surfaces encrophiles, des surfaces non encrophiles très petites (88 µm²) et très nombreuses (environ 25 fois plus). La surface encrophile de la plaque est ainsi criblée de ces petites surfaces qui malheureusement la fragilisent. Par ailleurs, la réalisation, à l'échelle industrielle, desdites minuscules surfaces est très difficile à mettre en oeuvre à des prix raisonnables.

D'une manière générale, l'allégement ainsi mis en oeuvre avec une trame classique - trame dite à modulation d'amplitude - modifie trop l'impression, ce qui s'avère regrettable pour de nombreux travaux. De plus, il convient pour ladite mise en oeuvre de prendre des précautions afin d'éviter le phénomène de moirage.

La mise en oeuvre de l'allégement, tel que préconisé dans la demande FR-A-2 660 245 n'a donc pas, à ce jour, donné pleinement satisfaction.

On en propose, selon la présente invention, une mise en oeuvre originale, particulièrement performante. Ladite mise en oeuvre fait intervernir un tramage à modulation de fréquence ou tramage stochastique.

Un tel tramage n'utilise pas des surfaces de points plus ou moins importantes pour reproduire les différentes valeurs de teintes, comme c'est le cas avec les trames classiques dites à modulation d'amplitude, mais un nombre de points, tous de la même surface, qui varie par exemple de 1 à 100 pour reproduire ces valeurs de 1 à 100 %. Selon ce tramage, lesdits points de même surface sont répartis de manière aléatoire. En d'autres termes, avec le tramage à modulation de fréquence, tous les points ont la même taille, généralement très petite, mais leur nombre par zone de surface (leur fréquence) varie selon la valeur des tons à reproduire, et leur répartition spatiale obéit à un calcul précis des adresses de rangement (procédé de randomisation). Une telle répartition comporte malheureusement la présence d'agglomérats de points.

La modulation de fréquence n'est pas, dans l'industrie, un procédé nouveau. Elle a été utilisée en basse résolution pour l'affichage numérique, la télécopie... Elle n'a toutefois été introduite dans l'industrie de l'impression qu'après le Seybold de Boston en avril 1993. (A cette occasion, les professionnels ont appris que le groupe d'entreprises Vignold de Essen travaillait sur ce sujet depuis 1992). A partir de cette date là, de nombreux articles ont paru sur le sujet (Deutsher Drucker, vol. 30, n° 10, Février 1994, p. W11-W13 et p. W14-W15). Plusieurs sociétés proposent, sur le marché, ce type de tramage. La société Agfa propose sa technologie Agfa Cristalraster, la société Linotype-Hell sa technologie Diamond Screening, la société Type Work GmbH sa technologie FINE GRAIN et la société Barco sa technologie MONET.

A ce jour, toutefois, les trames à modulation de fréquence, ou trames stochastiques, sont réservées à quelques rares travaux d'impression spécifiques. En fait, elles ne sont pratiquement pas employées dans la mesure où leur emploi pose de sérieux problèmes.

On reconnaît à l'emploi en impression de telles trames ces qualités indéniables; et notamment :
- l'absence de rosette.
- l'absence de moirage entre les couleurs,
- un repérage plus tolérant.

On formule toutefois à l'encontre de cet emploi des reproches :
- une copie des points sur la plaque offset très délicate. En effet, si l'on considère par exemple la trame Cristalraster d'Agfa qui a de gros points, ceux-ci ne présentent en fait que la surface d'un point de trame 1 % en trame classique 133 (trame à modulation d'amplitude), c'est-à-dire une surface de 362µm². Or, ceci est bien connu de l'homme du métier, à la copie du film sur la plaque, les normes utilisées ne permettent pas la reproduction d'un tel point de 1 %. Seule une modification de ces normes peut permettre la copie du 1% mais une telle modification est lourde, très difficile à mettre en oeuvre à l'échelle industrielle;
- une impression très délicate desdits points sur le papier en raison d'un engraissement important, difficile à éviter. En effet, sur machine à l'impression, le point est toujours reproduit avec une auréole. En pourcentage relatif, cette auréole est d'autant plus importante que le point est petit... Une reproduction fidèle avec de si petits points de trame est donc presque impossible... à moins que l'on ait spécialement modifié le film, et ceci, compte-tenu du document à reproduire, du matériau à imprimer, de l'encre utilisée... Une telle modification du film n'est pas chose aisée;
- une reproduction irrégulière dans l'échelle des valeurs de teinte. On observe en effet certaines cassures en raison, sans doute, de la formation aléatoire d'ensemble de petits points s'agglutinant les uns aux autres et formant ainsi de grandes surfaces encrophiles avec à côté de grandes surfaces non encrophiles, blanches. Ce point particulier, gérant à l'impression, semblait a priori exclure l'intérêt des trames stochastiques du contexte original de l'invention, i.e. de la dé-impression ou allégement. En effet, l'agglutination de petits points générant des surfaces importantes, leur intervention à la dé-impression ne pouvait qu'être fortement préjudiciable.

A ce jour donc, pour l'impression, les trames à modulation de fréquence ou trames stochastiques sont disponibles mais leur emploi reste extrêmement limité.

On propose, selon la présente invention, de les utiliser dans un contexte original, non pas pour l'impression en offset mais pour la dé-impression, en fait pour l'allégement des surfaces imprimantes au sens de la demande FR-A-2 660 245.

Selon son premier objet, l'invention concerne donc l'utilisation du tramage à modulation de fréquence ou tramage stochastique pour alléger les surfaces imprimantes, en techniques d'impression offset sec ou offset humide.

On a rappelé ci-dessus d'une part que le principe de l'allégement avait été décrit dans la demande FR-A-2 660 245 et d'autre part les caractéristiques du tramage à modulation de fréquence ou tramage stochastique. D'aucuns qualifient encore ce tramage de technologie à fréquence modulée.

Dans cette utilisation originale dudit tramage (à la dé-impression), on ne rencontre pas ou on réussit à éviter par une mise en oeuvre judicieuse (voir plus loin) les problèmes auxquels on est confronté avec celui-ci dans son utilisation classique (à l'impression). Au contraire, on a obtenu de façon surprenante des résultats très intéressants.

On n'a pas de réelles difficultés à mettre en oeuvre l'allégement (ceci est développé plus avant dans le présent texte) et ledit allégement, sous forme de petits points, d'une même faible superficie, distribués de manière aléatoire, n'est pas ou peut demeurer non préjudiciable au niveau de la qualité de l'impression. Au contraire, on améliore les conditions générales de ladite impression; cette amélioration étant d'autant plus sensible que le matériau à imprimer, papier notamment, est de moindre qualité. On a même constaté, de manière tout à fait surprenante, que les problèmes classiques rencontrés lors d'impressions avec très peu de surfaces encrophiles étaient de moindre intensité, voire supprimés lorsque lesdites surfaces encrophiles étaient allégées au sens de l'invention.

Plus précisément, l'application présentement proposée des trames stochastiques dans le but, non pas de créer des surfaces encrophiles pour déposer de l'encre sur un support mais au contraire de réduire la superficie de telles surfaces encrophiles selon le principe de l'allégement, a permis de mettre en oeuvre ledit allégement :
- sur tous les papiers,
- de façon aisée (tous les travaux peuvent être réalisés avec seulement une ou deux grosseurs de points),
- à des pourcentages d'allégement relativement forts; jusqu'à près de 30 % dans certain cas particuliers (sans grand préjudice sur la qualité de l'impression: guère d'incidence sur le contraste et la densité des surfaces encrées, sans provoquer de hachures).
- avec un fort impact positif sur le "tirant" des encres,
- sans générer de moirage.

Ainsi, un allégement de 10-12 %, parfaitement acceptable s'il est mis en oeuvre avec un tramage stochastique dans des conditions adéquates et qui, au niveau du "tirant" apporte un progrès considérable, ne peut être acceptable s'il est mis en oeuvre avec un tramage à modulation d'amplitude (problème de la dé-impression).

De tels résultats positifs de l'allégement stochastique n'étaient nullement prévisibles.

On met toutefois évidemment en oeuvre ledit allégement dans des limites raisonnables.

On utilise généralement selon l'invention ledit tramage à modulation de fréquence pour alléger lesdites surfaces imprimantes de 2 à 26 %, avantageusement de 8 à 14 %. On a obtenu des résultats très satisfaisants, sur plusieurs papiers assez différents, avec un allégement de 6 - 14%. De façon surprenante, de tels allégements ne se révèlent pas préjudiciables à l'impression même sur de beaux papiers, dans la mesure où ils sont mis en oeuvre de façon adéquate.

On précise ici que l'on utilise généralement aux fins de l'invention les trames stochatisques les plus couramment utilisées à ce jour - aux fins d'impression - i. e. celles produisant des petits points d'une superficie d'environ 400 µm².

On n'exclut toutefois nullement du cadre de l'invention, l'utilisation de trames stochastiques
- à plus petits points (d'une superficie d'environ 196 µm², par exemple) pour des travaux sur du très beau papier, lisse (timbres-poste, cartes postales);
- à plus gros points (d'une superficie pouvant atteindre 1 600 µm²) pour des travaux sur du papier grossier type papier journal.

L'allégement selon l'invention est mis en oeuvre pour un travail donné avec des points de même superficie, répartis de manière aléatoire, généralement des points d'environ 400 µm². Mais, on dispose tout-de-même d'un certain degré de liberté dans le choix de la superficie desdits points pour un taux d'allégement donné.

Pour la mise en oeuvre dudit allégement, on fait intervenir, dans les procédés classiques d'offset, sec ou humide, des logiciels, films ou plaques, aptes à générer des surfaces imprimantes allégées selon un tramage stochastique. Lesdits films ou plaques constituent le second objet de la présente invention. Comme précisé ci-dessus, leurs surfaces imprimantes, allégées selon un tramage stochastique, le sont généralement de 2 à 26 %, avantageusement de 8 à 14 %.

En fait, l'invention a également pour objet, l'utilisation, en techniques d'impression offset sec ou offset humide, de logiciels, aptes à générer des surfaces imprimantes allégées selon un tramage stochastique, pour la préparation de films ou plaques.

On décrit ci-après, plus en détail, lesdits films et plaques aptes à générer des surfaces imprimantes allégées selon un tramage stochastique.

Pour ce qui concerne les films, allégés au sens de l'invention, ils présentent, selon qu'il s'agit de films représentant le document à reproduire négatifs ou positifs, de petites surfaces noires d'allégement dans les parties transparentes ou de petites surfaces transparentes d'allégement dans les parties noires, lesdites petites surfaces étant distribuées, de façon caractéristique selon un tramage stochastique.

De tels films sont avantageusement réalisés chez le photograveur. On peut :
- soit réaliser les films (positifs ou négatifs) de telle manière que les parties encrophiles reproduisant le document aient été allégées selon un tramage stochastique;
- soit utiliser, pour photographier le document à reproduire, des films pré-traités sur lesquels, par impression ou par insolation, on a introduit préalablement les petites surfaces noires ou transparentes.

En fait, on met en oeuvre sur les films vierges une insolation adéquate pour générer de petites surfaces noires d'allégement dans les parties transparentes ou de petites surfaces transparentes d'allégement dans les parties noires; sachant que la lumière envoyée sur lesdits films vierges génère sur ceux-ci des surfaces noires. Cette technique d'insolation ne soulève aucun problème particulier.

Toutefois, le demandeur a constaté que sa mise en oeuvre classique pour générer de petites surfaces transparentes d'allégement dans les parties noires posait problème dans certains contextes au-delà d'un certain taux d'allégement. On observait alors des agglomérats de points d'allégements, agglomérats préjudiciables à l'impression. Le taux d'allégement au-delà duquel on observe, de façon non tolérable, de tels agglomérats dépend évidemment des conditions d'impression.

En tout état de cause, le demandeur a trouvé une astuce de préparation des films qui permet d'alléger l'impression à des taux d'allégement supérieurs à 5 %, sans préjudice à ladite impression mise en oeuvre sur tout papier et toute machine... Cest grâce à cette astuce que l'on peut préconiser dans le cadre de la présente invention, l'allégement, selon un tramage stochastique, jusqu'à des taux voisins de 30 %, et plus particulièrement jusqu'à des taux d'environ 14 % sur de très beaux papiers.

Ainsi donc, pour préparer des films qui présentent de petites surfaces transparentes d'allégement dans les parties noires, films utiles à la préparation de plaques positives, peut-on procéder de deux manières.

Selon la première, de façon classique, on insole un film vierge pour créer directement sur celui-ci, les petites surfaces transparentes requises, réparties de façon aléatoire. Le film obtenu ne présentera pas d'agglomérat si lesdites petites surfaces sont introduites à faible taux (faible taux d'allégement), en présentera en quantité de plus en plus importante si l'on augmente la quantité d'introduction de telles petites surfaces (fort taux d'allégement). Ceci peut toutefois rester acceptable dans certaines conditions particulières d'impression.

Selon la seconde, de façon originale, on procède en deux étapes. On insole un premier film pour créer sur celui-ci de petites surfaces noires, réparties de façon aléatoire puis on copie ledit premier film sur un second qui constitue le film allégé recherché. De façon surprenante, grâce à cette technique en deux étapes, on peut préparer des films à fort taux d'allégement qui ne présentent pas d'agglomérats de surfaces transparentes.

Les films traités - allégés selon un tramage stochastique - sont utilisés pour insoler des plaques. Lesdites plaques présentent de façon caractéristique des surfaces encrophiles et des surfaces non encrophiles ; une partie au moins desdites surfaces encrophiles renfermant de petites surfaces non encrophiles d'allégement, distribuées selon un tramage stochastique. On rappelle ici que lesdites petites surfaces, tant au niveau des plaques que des films, présentent théoriquement la même surface et sont distribuées de manière aléatoire (tramage stochastique).

Les plaques allégées au sens de l'invention sont des plaques positives ou négatives. Sur ces deux types de plaques, l'allégement n'a pas été mis en oeuvre de la même manière.

Pour ce qui concerne les plaques positives, on sait que la couche encrophile photosensible est, par insolation, rendue soluble dans le révélateur. Il faut donc, pour créer de petites surfaces non encrophiles dans la couche encrophile photosensible, envoyer de la lumière à travers un film qui présente les petites surfaces transparentes adéquates (selon un tramage stochastique). Ceci ne soulève aucun problème. En effet, l'homme du métier sait que la copie d'un film présentant des surfaces transparentes d'une superficie comprise entre environ 200 et 2 000 µm² se fait sans difficulté aucune.

L'insolation de la plaque positive, au travers dudit film, peut se faire à différents stades. Elle est avantageusement réalisée en amont du procédé d'impression, préalablement à toute utilisation de la plaque. On peut ainsi envisager de mettre sur le marché des plaques pré-insolées, (ayant subi l'insolation d'allégement et avantageusement non développées). De telles plaques positives font partie intégrante de la présente invention. Elles sont caractérisées en ce qu'elles comportent une couche encrophile photosensible qui a été insolée avec une trame stochastique.

De telles plaques pré-insolées peuvent être utilisées :
- pour, directement, une seconde insolation avec un film positif qui comporte le document à imprimer et un unique développement ;
- pour un premier développement suivi d'une seconde insolation avec un film positif qui comporte le document à imprimer et un second développement.

On peut, selon d'autres variantes :
- insoler, une première fois, une plaque positive avec le document à imprimer, la développer, la reprendre pour une seconde insolation au travers dudit film d'allègement et un second développement (on a ainsi introduit les petites surfaces non encrophiles dans les surfaces encrophiles) ;
- insoler une plaque positive avec un unique film positif qui comporte à la fois le document à reproduire et les petites surfaces transparentes dans les parties noires et développer ladite plaque.

Pour ce qui concerne les plaques négatives, on sait, au contraire, que la couche encrophile photosensible est, par insolation, rendue insoluble dans le révélateur. Il faut donc, pour créer de petites surfaces non encrophiles dans les parties encrophiles, arrêter la lumière au travers d'un film qui présente les petites surfaces noires adéquates (selon un tramage stochastique).

Ceci peut être mis en oeuvre selon différentes variantes.

On peut, selon une première variante, faire le nécessaire au niveau du film négatif qui comporte le document à imprimer. Ledit film aura été pré-traité pour contenir les petites surfaces adéquates.

On peut, selon une seconde variante, faire le nécessaire au niveau de la copie de la plaque en faisant intervenir deux films : un film qui présente les petites surfaces noires adéquates (pour arrêter la lumière) et un film négatif qui comporte le document à imprimer. La manipulation de ces deux films peut se révéler délicate...

On peut, selon une autre variante, faire le nécessaire au niveau de la plaque, avant de l'utiliser avec le film qui comporte le document à reproduire. On dépose sur la couche encrophile photosensible de ladite plaque, de petites surfaces opaques. Pour cela, on peut copier dans un premier temps sur une plaque offset négative de préférence Waterless un film qui comporte les petites surfaces transparentes d'allègement. Après insolation et développement, on obtient une plaque dont les parties encrophiles représentent les petites surfaces, qui vont déposer l'encre sur les plaques négatives. Pour renforcer l'opacité de l'encre ainsi déposée, on passe du talc, du noir de fumée ou équivalent. On est ainsi certain d'arrêter complètement la lumière au niveau desdites petites surfaces. On a observé par ailleurs que l'ensemble encre-talc ou noir de fumée qui confére auxdites petites surfaces un certain relief diminue ensuite le temps pour faire le vide dans le châssis à l'insolation. Il se comporte comme un agent anti-flou, lorsque l'on fait le vide dans ledit châssis pour un parfait plaquage du film comportant le document à reproduire. Ce procédé est donc particulièrement préféré. On peut également déposer directement sur la plaque, par jet d'encre, ladite encre qui arrêtera la lumière.

On peut, selon une autre variante, faire le nécessaire au niveau de la préparation de la plaque, au niveau de la solidarisation de sa surfaces hydrophile et de sa couche encrophile photosensible. On peut ainsi déposer sur ladite surface hydrophile une matière qui empêche l'adhérence de la couche encrophile négative en des endroits (distribués selon une trame stochastique), qui représenteront lesdites petites surfaces non encrophiles dans les parties encrophiles. Cette technique peut de la même façon être mise en oeuvre pour la préparation de plaques positives.

Quelle que soit la technique retenue, l'allégement selon un tramage stochastique ne pose pas de sérieux problème technique. On ne fait sauter, selon l'invention, que de petits points, en relativement faible quantité. Le bilan dudit allégement est toutefois très positif.

L'invention est illustrée par les exemples ci-après.

### Exemple 1

On utilise la trame stochastique Agfa Cristalraster de la société Agfa, trame "à gros points" pour générer, à raison de 5 %, des surfaces transparentes de 362 µm² chacune, sur un film.

On prend une plaque positive pré-sensibilisée et on l'insole avec ledit film dans un châssis. Des milliers de petites surfaces de 362 µm² voient ainsi la lumière et pourront être éliminées au développement.

On insole ensuite (seconde insolation) ladite plaque avec le motif à imprimer, on la développe et la gomme, comme à l'accoutumée. En considérant avec une loupe ladite plaque, on peut voir que toutes ses parties encrophiles contiennent, réparties d'une manière aléatoire, de petites surfaces où la couche encrophile a été éliminée au développement.

On met la plaque sur machine. On alimente ladite machine avec du papier ordinaire qui requiert, pour une bonne impression, une encre allongée et un film d'encre épais.

On constate que l'impression avec une telle plaque est d'une qualité supérieure à celle obtenue avec une plaque "non allégée". Ladite impression est, par ailleurs, mise en oeuvre avec moins de lavages du blanchet et on observe que le papier ne glisse pas dans les pinces.

### Exemple 2

On copie une plaque positive que l'on développe normalement.

On reprend ladite plaque développée pour l'insoler avec un film "allégé" du type de celui préparé dans l'exemple 1.

Après développement (second développement), on obtient une plaque du type de celle obtenue à l'exemple 1. Ses parties encrophiles renferment de petites surfaces non encrophiles (sans couche encrophile) réparties de manière aléatoire.

Les résulats à l'impression sont identiques à ceux de l'exemple 1.

### Exemple 3

On utilise un film "allégé" du type de celui préparé dans l'exemple 1 pour copier une plaque négative d'offset sec ("waterless"').

Avec ladite plaque, mise sur machine, on dépose sur des plaques offset négatives des milliers de petits points. Ceux-ci sont rendus plus opaques en les recouvrant de talc ou de noir de fumée. Lesdits petits points, rendus opaques, sont ainsi susceptibles d'arrêter la lumière (d'empêcher le durcissement de la couche encrophile).

On insole ladite plaque pré-traitée, avec un film négatif du motif à imprimer.

Cette plaque, avec moins de problèmes, assure une qualité supérieure d'impression. On constate également que lesdits petits points, d'une hauteur d'environ 2µm, facilitent l'évacuation de l'air, lorsque l'on fait le vide dans le châssis. En fait, ils se comportent comme des agents "anti-flou", en permettant au film d'être plaqué autour d'eux.

### Exemple 4

On prend une plaque positive pré-sensibilisée et on l'insole dans un châssis avec un film réalisé avec une trame stochastique MONET de la société Barco, dont les points transparents ont une superficie d'environ 390 µm² et représentent 12 % de la surface du film. Ledit film a été réalisé de la manière précisée ci-après.

Un premier film a été préparé de manière classique avec 88 % de surfaces transparentes et donc 12 % de petits points noirs, dispersés pratiquement sans agglomérat. On a ensuite copié ledit film sur un second dans un chassis. Après développement, ledit second film présente 12 % de surfaces transparentes, formées de petits points d'environ 390 µm². Lesdits petits points ne présentent pratiquement pas d'agglomérats gènants.

On insole ensuite (seconde insolation) ladite plaque avec le motif à imprimer; on la développe et on la gomme comme à l'accoutumée.

Avec un microscope, on peut voir que toutes les parties encrophiles, contiennent des petites surfaces isolées où la couche est partie au développement, et, qui sont disposées d'une manière aléatoire.

On met sur machine ladite plaque et on imprime en noir sur du beau papier couché des reproductions de photographies.

On constate que l'impression est bien dépouillée et que le tirage se fait plus facilement; la feuille de papier adhérant peu au blanchet en caoutchouc.

### Exemple 5

On procède comme dans l'exemple 4 mais avec un film ayant seulement 4% de surface transparente formée par des petits points transparents de 390 µm².

L'impression et les conditions d'impression sont sensiblement inférieures à celles de l'exemple 4 .

### Exemple 6 (exemple comparatif)

On utilise pour l'allégement un film ayant 12 % de surfaces transparentes (comme dans l'exemple 4) mais réalisé avec une trame conventionnelle (trame à modulation d'amplitude) qui a 300 linéatures au pouce (trame très fine).

Pour obtenir les 12 % de surface transparentes, les points ont une surface d'environ 850 µm². Après mise sur machine de la plaque allégée avec ladite trame conventionnelle, on constate que la densité dans les aplats a baissé d'environ 10 % et que des points blancs sont visibles dès que l'encrage baisse un peu.

De plus, les reproductions des photographies sont plus contrastées; des détails fins ont plus ou moins disparus et des traits minces sont par endroits hachurés. Par ailleurs, on observe un certain moirage, si l'écart de 30° dans le positionnement des deux films (film d'allégement et film comportant le motif à imprimer) n'a pas été respecté.

### Exemple 7

On procède comme dans l'exemple 4, mais la surface transparente représente 16 % de la surface du film et cela sans agglomérat de points gênant.

Le papier est du type papier-journal et les reproductions sont réalisées dans les conditions classiques d'impression des journeaux.

L'impression et les conditions d'impression sont bonnes.

### Exemple 8

On procède, comme dans l'exemple 4, mais le film d'allégement a été réalisé avec la trame stochastique de manière classique (directement).

La qualité d'impression, sur un beau papier couché, est inférieure (présence d'agglomérats des petits points d'allégement).

Toutefois, la qualité obtenue serait acceptable avec d'autres supports d'impression de qualité moins bonne.

## Revendications

1. Utilisation du tramage à modulation de fréquence ou tramage stochastique pour alléger les surfaces imprimantes, en techniques d'impression offset sec ou offset humide.

2. Utilisation selon la revendication 1, pour alléger lesdites surfaces imprimantes de 2 à 26 %, avantageusement de 8 à 14 %.

3. Films, plaques, utiles à l'impression en offset sec ou humide, aptes à générer des surfaces imprimantes allégées, caractérisés en ce que ledit allégement est selon un tramage stochastique.

4. Films, plaques selon la revendication 3, caractérisés en ce que les surfaces imprimantes sont allégées de 2 à 26 %, avantageusement de 8 à 14 %.

5. Films selon l'une des revendications 3 ou 4 caractérisés en ce qu'ils présentent de petites surfaces noires d'allégement dans les parties transparentes ou de petites surfaces transparentes d'allégement dans les parties noires ; lesdites petites surfaces d'allégement étant distribuées selon un tramage stochastique.

6. Procédé pour la préparation de films, selon l'une quelconque des revendications 3 à 5, qui présentent de petites surfaces transparentes d'allégement dans les parties noires; ledit procédé comprenant :
- l'insolation d'un film vierge pour créer directement sur ledit film vierge des petites surfaces transparentes, selon un tramage stochastique; lesdites petites surfaces transparentes couvrant le pourcentage de la superficie dudit film correspondant au taux d'allégement désiré;
ou
- l'insolation d'un premier film vierge pour créer sur celui-ci, des petites surfaces noires, selon un tramage stochastique; lesdites petites surfaces noires couvrant le pourcentage de la superficie dudit premier film correspondant au taux d'allégement désiré; puis la copie par contact dudit premier film sur un second film pour créer sur ledit second film des petites surfaces transparentes, selon ledit tramage stochastique; lesdites petites surfaces transparentes couvrant le pourcentage de la superficie dudit second film correspondant au taux d'allégement désiré.

7. Plaques selon l'une des revendications 3 ou 4, caractérisées en ce qu'elles présentent des surfaces encrophiles et des surfaces non encrophiles ; une partie au moins desdites surfaces encrophiles renfermant de petites surfaces non encrophiles d'allègement, distribuées selon un tramage stochastique.

8. Plaques selon l'une des revendications 3 ou 4, caractérisées en ce qu'elles comportent une surface hydrophile recouverte d'une couche encrophile photosensible, ladite couche encrophile photosensible n'adhérant pas, en de petites surfaces, distribuées selon un tramage stochastique, à ladite surface hydrophile.

9. Plaques positives selon l'une des revendications 3 ou 4, caractérisées en ce qu'elles comportent une surface hydrophile recouverte d'une couche encrophile photosensible qui a été insolée avec une trame stochastique.

10. Plaques négatives selon l'une des revendications 3 ou 4, caractérisées en ce qu'elles comportent une surface hydrophile recouverte d'une couche encrophile photosensible, ladite couche encrophile présentant de petites surfaces opaques, distribuées selon un tramage stochastique.

11. Utilisation, en techniques d'impression offset sec ou offset humide, de logiciels, aptes à générer des surfaces imprimantes allégées selon un tramage stochastique, pour la préparation de films ou plaques.

## Patentansprüche

1. Verwendung frequenzmodulierter Rasterung oder stochastischen Rasterung zum Abschwächen der Druckflächen bei Trocken- oder Naß-Offset-Drucktechniken.

2. Verwendung nach Anspruch 1 zum Abschwächen der genannten Druckflächen um 2 bis 26%, vorteilhafterweise um 8 bis 14%.

3. Folien und Platten, die zum Trocken- oder Naß-Offsetdruck verwendbar sind und dazu eingerichtet sind, abgeschwächte Druckflächen zu erzeugen, dadurch gekennzeichnet, daß die genannte Abschwächung in stochastischer Rasterung erfolgt.

4. Folien und Platten nach Anspruch 3, dadurch gekennzeichnet, daß die Druckflächen um 2 bis 26%, vorteilhafterweise um 8 bis 14%, abgeschwächt sind.

5. Folien nach einem der Ansprüche 3 oder 4, dadurch gekennzeichnet, daß sie kleine, schwarze Abschwächungsflächen in den transparenten Abschnitten oder kleine, transparente Abschwächungsflächen in den schwarzen Abschnitten aufweisen, wobei die genannten Abschwächungsflächen in stochastischer Rasterung verteilt sind.

6. Verfahren zur Vorbereitung von Folien nach irgendeinem der Ansprüche 3 bis 5, die kleine, transparente Abschwächungsflächen in den schwarzen Abschnitten aufweisen, wobei das genannte Verfahren die folgenden Schritte aufweist:
- das Absondern eines Rohfilms, um unmittelbar auf dem genannten Rohfilm kleine, transparente Oberflächen in stochastischer Rasterung zu erzeugen, wobei die genannten kleinen Oberflächen den Prozentsatz der Oberfläche des genannten Filmes abdecken, der dem Maß der angestrebten Abschwächung entspricht;
oder
- das Absondern eines ersten Rohfilms, um auf diesem kleine schwarze Flächen in stochastischer Rasterung zu erzeugen, wobei die kleinen, genannten, schwarzen Flächen den Prozentsatz der Oberfläche des genannten Filmes abdecken, der dem Maß der angestrebten Abschwächung entspricht; dann die Kontaktkopie des genannten ersten Filmes auf einem zweiten Film, um auf dem genannten zweiten Film kleine transparente Oberflächen in der genannten stochastischen Rasterung zu erzeugen, wobei die genannten transparenten Oberflächen den Prozentsatz der Oberfläche des genannten zweiten Films abdecken, der dem angestrebten Maß der Abschwächung entspricht.

7. Platten nach einem der Ansprüche 3 oder 4, dadurch gekennzeichnet, daß sie farbaufnehmende und nicht-farbaufnehmende Oberflächen darbieten. wobei mindestens ein Teil der genannten farbaufnehmenden Oberflächen kleine, nicht-farbaufnehmende Abschwächungsoberflächen einschließt, die in stochastischer Rasterung verteilt sind.

8. Platten nach einem der Ansprüche 3 oder 4, dadurch gekennzeichnet, daß sie eine wasseraufnehmende Oberfläche aufweisen, die mit einer farbaufnehmenden, lichtempfindlichen Abdeckung abgedeckt ist, wobei die genannte farbaufnehmende, lichtempfindliche Abdeckung in kleinen Oberflächen, die in stochastischer Rasterung verteilt sind, nicht an der genannten wasseraufnehmenden Oberfläche anhaftet.

9. Positiv-Platten nach einem der Ansprüche 3 oder 4, dadurch gekennzeichnet, daß sie eine wasseraufnehmende Oberfläche aufweisen, die mit einer farbaufnehmenden, lichtempfindlichen Abdeckung abgedeckt ist, die in stochastischen Rasterung aufgetrennt wurde.

10. Negativ-Platten nach einem der Ansprüche 3 oder 4, dadurch gekennzeichnet, daß sie eine wasseraufnehmende Oberfläche aufweisen, die mit einer farbaufnehmenden, lichtempfindlichen Abdeckung abgedeckt ist, wobei die genannte farbaufnehmende Abdeckung kleine, opake Oberflächen dabietet, die in stochastischer Rasterung verteilt sind.

11. Verwendung von Softwares bei Trocken- oder Naß-Offsetdrucktechniken, wobei die Softwares dazu eingerichtet sind, abgeschwächte Druckflächen in stochastischer Rasterung für die Herstellung von Folien oder Platten zu erzeugen.

## Claims

1. Use of frequency-modulated screening or stochastic screening for lightening the printing surfaces in waterless or wet offset printing techniques.

2. The use according to claim 1, for lightening said printing surfaces from 2 to 26%, advantageously from 8 to 14%.

3. Films, plates, useful for waterless or wet offset printing, adapted to generate lightened printing surfaces, characterized in that said lightening is according to a stochastic screening.

4. The films, plates according to claim 3, characterized in that the printing surfaces are lightened from 2 to 26%, advantageously from 8 to 14%.

5. The films according to one of claims 3 or 4, characterized in that they present small black lightening surfaces in the transparent parts or small transparent lightening surfaces in the black parts; said small lightening surfaces being distributed according to a stochastic screening.

6. Process for preparing films according to any one of claims 3 to 5, which present small transparent lightening surfaces in the black parts; said process comprising:
- the exposure of a blank film to create small transparent surfaces directly on said blank film according to a stochastic screening; said small transparent surfaces covering the percentage of the area of said film corresponding to the desired lightening rate;
or
- the exposure of a first blank film to create thereon small black surfaces according to a stochastic screening; said small black surfaces covering the percentage of the area of said first film corresponding to the desired lightening rate; then the copy by contact of said first film on a second film to create on said second film small transparent surfaces according to said stochastic screening; said small transparent surfaces covering the percentage of the area of said second film corresponding to the desired lightening rate.

7. The plates according to one of claims 3 or 4, characterized in that they present inkphilic surfaces and non-inkphilic surfaces; at least one part of said inkphilic surfaces containing small non-inkphilic lightening surfaces, distributed according to a stochastic screening.

8. The plates according to one of claims 3 or 4, characterized in that they comprise a hydrophilic surface coated with a photosensitive inkphilic layer, said photosensitive inkphilic layer not adhering, in small surfaces distributed according to a stochastic screening, to said hydrophilic surface.

9. Positive plates according to one of claims 3 or 4, characterized in that they comprise a hydrophilic surface coated with a photosensitive inkphilic layer which has been exposed with a stochastic screen.

10. Negative plates according to one of claims 3 or 4, characterized in that they comprise a hydrophilic surface coated with a photosensitive inkphilic layer, said inkphilic layer presenting small opaque surfaces distributed according to a stochastic screening.

11. Use, in waterless or wet offset printing techniques, of software adapted to generate printing surfaces lightened according to a stochastic screening, for preparing films or plates.
